# EUROPEAN PATENT APPLICATION

(11) **EP 4 641 239 A1**
(43) Date of publication of application: **29.10.2025**
(21) Application number: 24171509.3
(22) Date of filing: 22.04.2024
(51) Int. Cl.: G01R 33/38, G01R 33/3815

(54) **MOUNTING STRUCTURE FOR A MAGNETIC RESONANCE EXAMINATION SYSTEM**

(71) Applicant: Koninklijke Philips N.V., 5656 AG Eindhoven (NL)
(72) Inventor: PAARDENKOOPER, Timotheus, Eindhoven (NL)
(74) Representative: Philips Intellectual Property & Standards

(57) **Abstract**

The invention relates to a mounting structure (4) for a medical examination system (3), the mounting structure (4) being configured for being placed onto a loading surface (6) and comprising: elastically resilient elements (7) for supporting the medical examination system (3) on the loading surface (6), transverse supports (8) for securing the medical examination system (3) from movements parallel to the loading surface (6), and low-friction slide plates (9) on the transverse supports (8) for contacting the medical examination system (3). In this way, a more crash-resistant solution for supporting a mobile medical examination system (3) allowing it to remain suspended while ensuring it stays attached to its loading surface (6) during an accident or collision, thereby offering a solution that combines safety with operational integrity. In a preferred embodiment the medical examination system (3) is a magnetic resonance examination system (3) comprising a superconducting magnet (5).

## Description

### FIELD OF THE INVENTION

The invention relates to the field of magnetic resonance examinations systems, in particular to mobile magnetic resonance examinations systems.

### BACKGROUND OF THE INVENTION

Mobile magnetic resonance (MR) examination systems, equipped with superconducting magnets, present unique challenges during transportation from one location to another, especially when they need to remain "on field." In this respect, "on field" means that the magnet's magnetic field is maintained throughout the transport. This condition is critical for ensuring the system is ready for use upon arrival without the lengthy and costly process of re-energizing the magnet. However, maintaining this state while moving the system presents several potential problems, particularly concerning quenching and heating of the coils. Therefore, transporting a magnetic resonance examination system equipped with a superconducting magnet particularly concerns challenges with respect to the induction of eddy currents due to vibrations, which can lead to heating, and the risk of quenching due to such heating. These issues are interconnected and can affect the stability and functionality of the superconducting magnet, which is a crucial component of magnetic resonance imaging (MRI) systems.

Eddy currents are loops of electrical current induced within conductors by a changing magnetic field in the conductor, according to Faraday's law of electromagnetic induction. During transport, a magnetic resonance examination system, particularly one with a superconducting magnet, is subject to various vibrations and shocks. These can originate from the movement of the vehicle, uneven road surfaces, and other mechanical impacts. The vibrations can change the magnetic field around the conductors in the system, leading to the induction of eddy currents. The problem with eddy currents is that they generate resistive heating in the material (Joule heating). Superconducting magnets used in MRI systems are designed to operate at extremely low temperatures, often only a few degrees above absolute zero, and are typically cooled with liquid helium. The induction of eddy currents and the subsequent heating can increase the temperature of parts of the magnet. The heating caused by eddy currents poses a significant risk to the superconducting magnet. If the temperature rises above the superconductor's critical temperature, the material can lose its superconducting properties. This loss of superconductivity is not uniform and can lead to hotspots within the magnet.

Quenching refers to a rapid loss of superconductivity in a superconducting magnet when part of the magnet transitions from the superconducting to the normal resistive state. This can be triggered by local heating due to eddy currents. Quenching is a critical problem because it can lead to a sudden and uncontrolled increase in temperature. During a quench, the entire magnetic energy stored in the magnet is released, often in the form of heat, which can cause rapid boiling off of the cooling liquid helium.

Therefore, MRI systems utilize superconducting magnets which are susceptible to quenching, where parts of the magnet abruptly lose their superconducting properties and revert to a normal, resistive state. This transition can generate intense heat, localized at a specific site, which could potentially damage the magnet's coils. To mitigate this risk, MRI systems are equipped with a sophisticated quench protection mechanism. This mechanism is designed to gently manage a quench by dispersing the resulting heat energy across multiple regions of the magnet, rather than allowing it to accumulate at a single point. By spreading out the heat, the system prevents the formation of excessively high temperature zones, or hotspots, that could cause irreversible damage to the magnetic coils.

It is desired to avoid any quench incidents altogether, particularly to minimize lengthy downtime associated with such events. Typically, after a quench, it can take up to about 24 to 72 hours, depending on the magnet type, to cool down the magnet and restore it to its operational superconducting state. This cooling period represents a significant operational delay, particularly in clinical settings where MRI scanners are in high demand.

Additionally, ensuring the safety of mobile MRI systems, which are often housed in trailers towed by trucks, is critical. In the event of a road traffic accident involving the vehicle carrying the MRI, the system must be robust enough to protect the sensitive superconducting magnet from shocks and impacts that could trigger a quench. This safety feature is crucial not only for protecting the expensive equipment but also for ensuring that the MRI system can be quickly and safely redeployed after an accident, without the need for extensive repairs or cooldown periods. Thus, the design of these systems emphasizes both accident resilience and rapid recovery, ensuring continuity of service and safety in mobile medical imaging applications.

For MRI magnets, new technologies exist that totally eliminate the venting of helium, such as "sealed technology" or "dry technology". But also with these technologies, magnet vibrations can lead to undesirable eddy current heating at the superconducting coils, resulting in a quench. As mentioned before, a quench, even without helium loss, is a very undesirable event because it results in downtime.

To summarize the situation in the prior art: Mobile MRI systems must remain operational during transportation between hospitals or other locations, meaning the magnet and its magnetic field must be preserved. If the coils overheat or experience a quench, causing them to lose their superconducting properties, the magnetic field is completely lost. MRI systems are often more vulnerable to quenches during road transport compared to stationary ones. Vibrations from rough roads can induce eddy currents that heat up internal components, risking the superconducting coil wires or connected circuitry reaching critical temperatures that could lead to a quench. Typically, the magnet, weighing between 3 to 5 tons, is directly attached to the steel underbody beams of a trailer to ensure that it does not detach or roll off during an accident. However, such measures alone may not provide sufficient strength to keep the magnet secured to the trailer in the event of a collision.

US 2020/0072408 A1 discloses a support stand for supporting a magnetic resonance imaging scanner while in operation. An MRI scanner includes a cylindrical housing having a lateral surface extending parallel to a horizontal patient bore to encapsulate a main cylindrical magnet. The cylindrical housing defines a longitudinal footprint dimension and a lateral footprint dimension. The support stand includes a base and a plurality of pillars extending upright from the base. Each respective pillar includes a first end mounted to the base and an opposing second end. The support stand also includes a vibration isolator mounted at the second end of the respective pillars to support the lateral surface of the cylindrical housing. The respective vibration isolators minimize transmission of environment borne vibrations to the MRI scanner or minimize transmission of MRI scanner generated vibrations to the environment.

### SUMMARY OF THE INVENTION

It is an object of the invention to provide a more crash-resistant solution for supporting a mobile medical examinations system, allowing it to remain suspended while ensuring it stays attached to its loading surface during an accident or collision, thereby offering a solution that combines safety with operational integrity.

According to the invention, this object is addressed by the subject matter of the independent claims. Preferred embodiments of the invention are described in the dependent claims.

Therefore, according to the invention, a mounting structure for a medical examination system is provided, wherein the mounting structure is configured for being placed onto a loading surface and comprises elastically resilient elements for supporting the medical examination system on the loading surface, transverse supports for securing the medical examination system from movements parallel to the loading surface, and low-friction slide plates on the transverse supports for contacting the medical examination system.

The medical examination system may be a medical imaging system, such as for example a magnetic resonance imaging (MRI) system, a computer tomography (CT) system, a diagnostic X-ray (DXR) system, radiation therapy (MR-Linac) system. In a preferred embodiment the medical examination system is a magnetic resonance imaging system comprising a superconducting magnet. In a further preferred embodiment, the medical examination system is a mobile medical examination system.

In operation, the elastically resilient elements limit transverse motion and the transverse supports prevent axial and lateral motions, i.e. movements substantially parallel to the loading surface. In this way eddy current generation is reduced. Therefore, the overall dimensions of the mounting structure are such that in operation, the magnetic resonance examination system can just be positioned in and on the mounting structure with very little play but can then practically no longer perform any horizontal movements.

According to an embodiment of the invention, in operation, the low-friction slide plates on the transverse supports provide a stop surface for the magnetic resonance examination system that runs perpendicular to the loading surface. This embodiment is directed to a typical use in which the loading surface is a flat loading surface, e.g., on a trailer which is pulled by a truck. Under low-friction slide plate is understood a plate with a surface that allows considerably larger movement of an abutting surface of the magnetic resonance examination system than when the two abutting surfaces would be of metal or when one of the abutting surfaces would be of metal and the other one of an elastomer.

Preferably, the surface of the low-friction slide plates comprises polytetrafluoroethylene (PTFE, Teflon). PTFE stands out for its exceptionally low friction properties, making it an excellent choice for low-friction plates. Its low coefficient of friction ensures minimal resistance and wear, enhancing smooth operation and efficiency. PTFE's resilience against a broad spectrum of chemicals, coupled with its ability to withstand extreme temperatures, makes it versatile for diverse applications. The material's self-lubricating nature eliminates the need for additional lubrication, while its durability and non-stick surface contribute to reduced maintenance and longer lifespan. PTFE is also characterized by its electrical insulation capabilities and water and moisture resistance.

Alternative to PTFE, other low-friction materials may be used, such as ultra-high-molecular-weight polyethylene (UHMWPE), polyether ether ketone (PEEK), BAM (combination of AlMgB₁₄ with TiB₂). BAM is particularly advantageous for its hardness.

While the elastically resilient elements may be manufactured in many different ways, according to an embodiment of the invention, the elastically resilient elements comprise elastic pads which are made from an elastic material and/or springs. The elastic material may be an elastomer or a similar material. An elastomer is a type of polymer with viscoelasticity, meaning it has both viscosity and elasticity and hence good damping properties. Damping refers to the reduction of vibrational or oscillatory motion through dissipation of energy. Elastomers are characteristically very flexible and elastic, capable of returning to their original shape after being stretched, compressed, or deformed. Elastomers are the base materials for a wide range of products due to their rubber-like properties. The molecular structure of elastomers consists of long, coiling chains that can be stretched out and then return to their original state due to their weak intermolecular forces. This property is what gives elastomers their notable elasticity. When an elastomer is undeformed, its molecules are randomly coiled, but when a force is applied, the chains straighten in the direction of the force. Once the force is removed, the molecules revert to their original, tangled state. The most common example of an elastomer is natural rubber, which is derived from the latex of rubber trees. However, there are many synthetic elastomers as well, such as neoprene, nitrile rubber, and silicone rubber. Elastomers can be formulated with different properties, including hardness, resilience, and heat resistance, to meet the specific requirements due to the heavy mass of a magnetic resonance examination system with a superconducting magnet, this mass easily exceeding several tons. For such application, elastomers may be manufactured through various manufacturing processes such as vulcanization, which involves adding sulfur or other curatives to cross-link the polymer chains, thereby increasing the material's strength and elasticity for supporting heavy masses.

Springs used for the present application, typically as a set of springs, are mechanical devices that store and release energy. They can be made from various materials, including metal, rubber, or plastic, and may be used in several forms, such as coil springs, leaf springs, and torsion springs, among others. The key functions of such springs in the context of the present invention is damping. In movement, excessive vibration can lead to premature wear, noise, and even failure of components of the magnet resonance examination system, especially of its superconducting magnet. Springs can help reduce these vibrations by absorbing energy, reducing the amplitude of the vibrations. Springs are excellent at absorbing shock loads, such as those experienced by vehicles as they travel over uneven surfaces. The spring compresses under the shock, absorbing energy and thereby reducing the force transmitted to the rest of the vehicle. The damping effect of a spring is primarily due to the material's inherent properties and the design of the spring itself. For instance, the coil design of the springs can be optimized to absorb and dissipate energy efficiently, even when supporting heavy masses.

According to an embodiment of the invention, the transverse supports are each provided with a slotted hole through which a sliding pin is fed which is fixed to the magnetic resonance examination system for allowing the magnetic resonance examination system to perform a limited vertical motion. In operation, the slotted holes run in a vertical direction. During operation, the limited vertical movement is restricted by the sliding pin hitting the upper or lower limit of the slotted hole, respectively. In this way, a certain vertical movement of the magnetic resonance examination system becomes possible while keeping the magnetic resonance examination system suspended on the elements in the event of a security incident. Preferably, the sliding pins are each provided with a thread for threading them into respective threaded holes in the magnetic resonance examination system.

The magnetic resonance examination system can include various types of mounting mechanisms to install the system at its intended location of use. However, according to an embodiment of the invention, the magnetic resonance examination system is provided with a foot structure for placing the magnetic resonance examination system onto a flat surface for operation, wherein the elastically resilient elements and the transverse supports with the low-friction slide plates are configured for supporting and securing the magnetic resonance examination system via its foot structure. Such a separate foot structure may make the system more stable and secure.

The invention also relates to the use of a mounting structure as described above for supporting and securing a magnetic resonance examination system with a superconducting magnet.

The invention further relates to a method for supporting and securing a magnetic resonance examination system with a superconducting magnet on a loading surface, the method comprising:
elastically supporting the magnetic resonance examination system on the loading surface, and
securing the magnetic resonance examination system from movements parallel to the loading surface, including contacting the magnetic resonance examination system with low-friction slide plates.

According to an embodiment of the invention, the method comprises:
placing a mounting structure onto the loading surface,
elastically supporting the magnetic resonance examination system on the loading surface by elastically resilient elements of the mounting structure,
securing the magnetic resonance examination system from movements parallel to the loading surface by transverse supports of the mounting structure, and
contacting the magnetic resonance examination system with low-friction slide plates which are arranged on the transverse supports.

According to an embodiment of the invention, the method comprises:
by the low-friction slide plates on the transverse supports, providing a stop surface for the magnetic resonance examination system that runs perpendicular to the loading surface.

According to an embodiment of the invention, the method comprises:
allowing the magnetic resonance examination system to perform a limited vertical motion.

According to an embodiment of the invention, the method comprises:
allowing the magnetic resonance examination system to perform a limited vertical motion by slotted holes in the transverse supports through which sliding pins are fed which are fixed to the magnetic resonance examination system.

This Summary is provided to introduce a selection of concepts in a simplified form that are further described below in the Detailed Description. This Summary is not intended to identify key features or essential features of the claimed subject matter, nor is it intended to limit the scope of the claimed subject matter. A more extensive presentation of features, details, utilities, and advantages of the system, as defined in the claims, is provided in the following written description of various embodiments of the disclosure and illustrated in the accompanying drawings.

### BRIEF DESCRIPTION OF THE DRAWINGS

These and other aspects of the invention will be apparent from and elucidated with reference to the embodiments described hereinafter. Such embodiments do not necessarily represent the full scope of the invention.

In the drawings:
Fig. 1 schematically depicts a prior art situation with a truck and a trailer in which a magnetic resonance examination apparatus is mounted;
Fig. 2a schematically depicts a side view of a mounting structure according to an embodiment of the invention, supporting a magnetic resonance examination system with a superconducting magnet on a loading surface;
Fig. 2b schematically depicts a front view of a mounting structure according to an embodiment of the invention, supporting a magnetic resonance examination system with a superconducting magnet on a loading surface;
Fig. 3a schematically depicts details of a mounting structure according to an embodiment of the invention, which allows vertical movement of the supported magnetic resonance examination system to an upper limit;
Fig. 3b schematically depicts details of a mounting structure according to an embodiment of the invention, which allows vertical movement of the supported magnetic resonance examination system to lower limit;
Fig. 4a schematically depicts an elastic pad, which can be used as an elastically resilient element according to an embodiment of the invention;
Fig. 4b schematically depicts a set of springs which can be used as an elastically resilient element according to an embodiment of the invention;
Fig. 5a schematically depicts a threaded hole in a side wall of a magnetic resonance examination system according to an embodiment of the invention;
Fig. 5b schematically depicts a threaded bolt for attaching to the threaded hole of Fig. 5a according to an embodiment of the invention.

### DETAILED DESCRIPTION OF EMBODIMENTS

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alteration and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may be implemented in a computer implemented method and/or in a computer program product, in a corresponding manner.

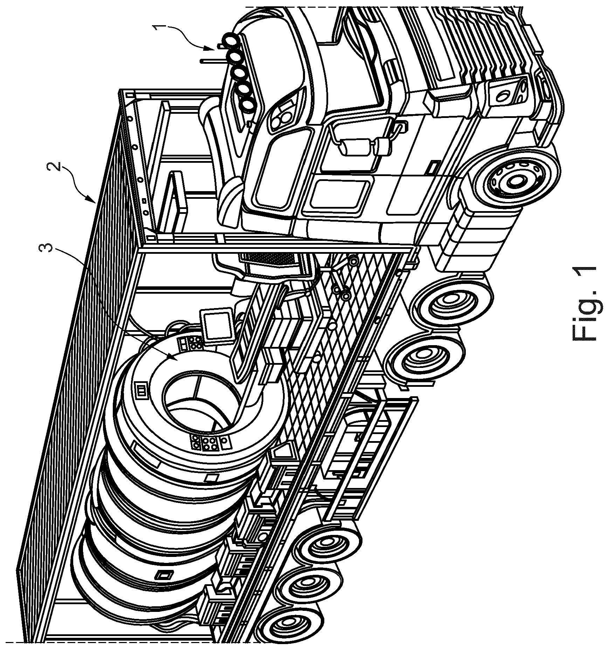

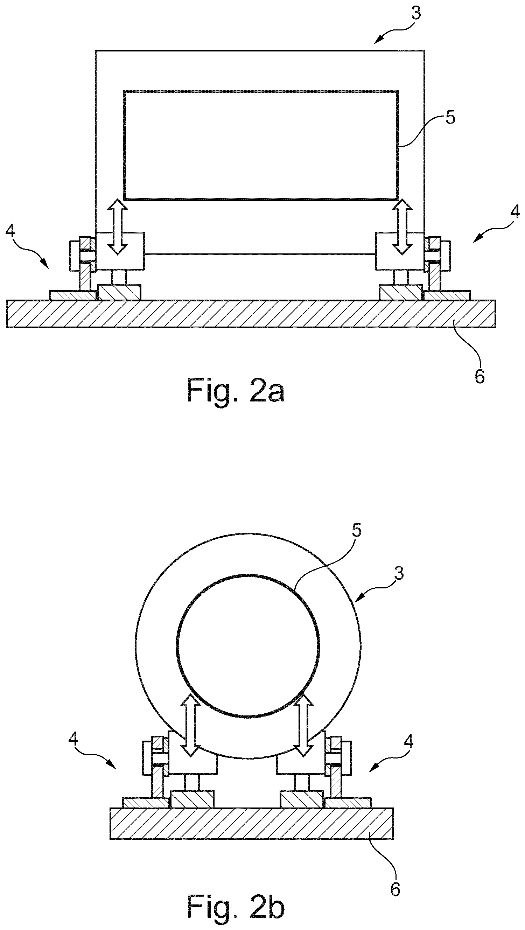

Fig. 1 schematically depicts a prior art situation with a trailer 2 pulled by a truck 1, wherein a magnetic resonance examination apparatus 3 is installed in the trailer 2. Such mobile MR systems need to stay operational and maintain their magnetic field while being transported. They are at risk of losing their superconducting properties and, consequently, their magnetic field if the magnet coils of the magnetic resonance examination apparatus 3 overheat or quench, especially during road transport due to vibrations and potential heating from eddy currents. This is where the invention comes in and proposes a mounting structure 4 for a magnetic resonance examination system 3 with a superconducting magnet 5, wherein the mounting structure 4 is configured for being placed onto a loading surface 6 and comprises elastically resilient elements 7 for supporting the magnetic resonance examination system 3 on the loading surface 6, transverse supports 8 for securing the magnetic resonance examination system 3 from movements substantially parallel to the loading surface 6, and low-friction slide plates 9 made for example from PTFE on the transverse supports 8 for contacting the magnetic resonance examination system 3. An embodiment of such a mounting structure supporting a magnetic resonance examination system 3 with a superconducting magnet 5 on a loading surface 6 is schematically depicted in Figs. 2a and 2b. As it can be seen from Figs. 2a and 2b, the mounting structure 4 is designed in such a way that the low-friction slide plates 9 on the transverse supports 8 provide a stop surface for the magnetic resonance examination system 3 that runs perpendicular to the loading surface 6. The stop surface should be understood as a surface of the respective low-friction slide plate that abuts a surface of the magnetic resonance examination surface. Although in the description it is generally referred to a mobile magnetic resonance examination apparatus 3 installed in the trailer 2, the invention is contemplated for transportation of magnetic resonance examination systems from factory to installation place in a hospital.

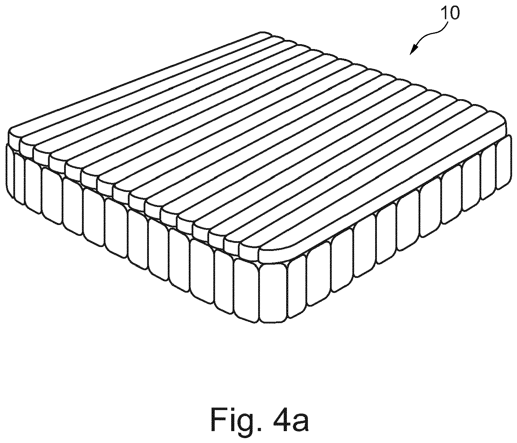

According to the embodiment illustrated in Figs. 2a and 2b, the elastically resilient elements 7 comprise elastic pads 10, which are made from an elastomer. An elastomer represents a polymer category characterized by viscoelasticity, possessing qualities of both viscosity and elasticity, which confer good damping capabilities. Such an elastic pad 10 is schematically depicted in Fig. 4a.

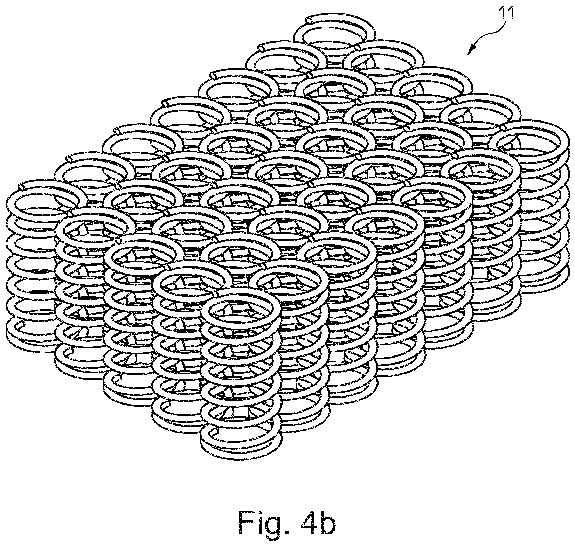

In an alternative embodiment, the elastically resilient elements 7 may be or may comprise set of springs 11, as schematically depicted in Fig. 4b.

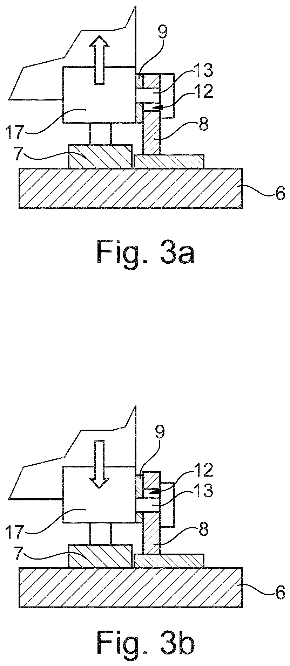

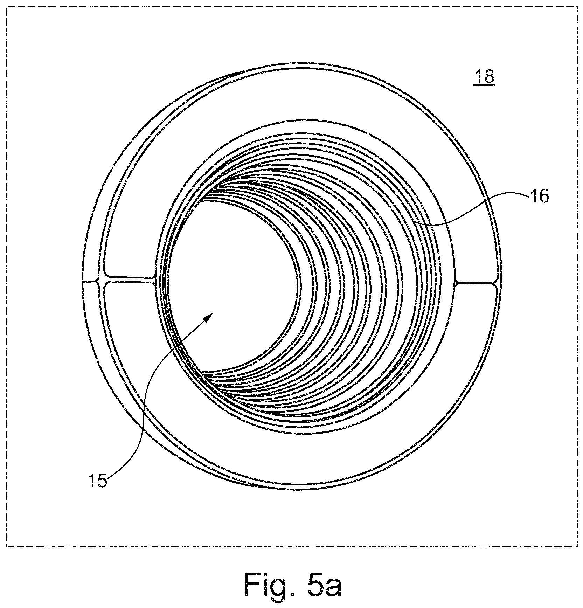

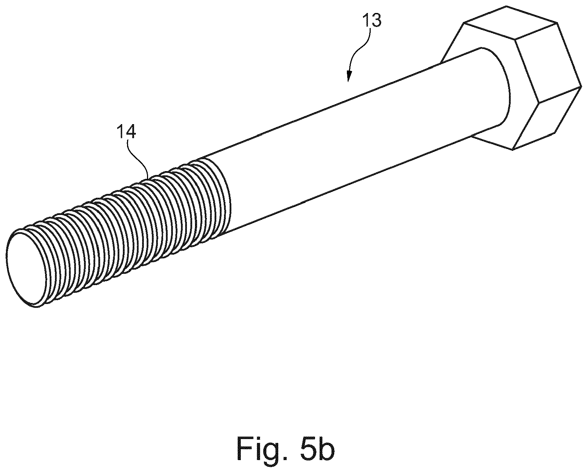

As schematically depicted in Figs. 3a and 3b, according to an embodiment of the invention described here, the transverse supports 8 are each provided with a slotted hole 12 through which a sliding pin 13 is fed which is fixed to the magnetic resonance examination system 3 for allowing the magnetic resonance examination system 3 to perform a limited vertical motion. Fig. 3a depicts the situation in which a vertical movement of the supported magnetic resonance examination system 3 is allowed to its upper limit, i.e. when the sliding pin 13 strikes the upper end of the slotted hole 12, while Fig. 3b depicts the situation in which a vertical movement of the supported magnetic resonance examination system 3 is allowed to its lower limit, i.e. when the sliding pin 13 strikes the lower end of the slotted hole 12. In general, the size and/or form of the slotted hole defines a predetermined vertical movement. As it can be understood from Fig. 5b, the sliding pins 13 are each provided with a thread 14 for threading them into respective threaded holes 15 in the magnetic resonance examination system 3, such threaded holes 15 being shown in Fig. 5a. It is understood that any other alternative fastening means to threads may be provided on the sliding pins, such as rivets, well nuts, petal nuts, etc., as far as they provide a portion that can act as sliding pin in the slotted hole.

From Figs. 3a and 3b, it can also be understood that the magnetic resonance examination system 3 comprises a foot structure 17 for placing the magnetic resonance examination system 3 onto a flat surface for operation, and that the elastically resilient elements 7 and the transverse supports 8 with the low-friction slide plates 9 support and secure the magnetic resonance examination system 3 via its foot structure 17.

Although the invention has been disclosed in detail in relation to magnetic resonance examination system, the invention is applicable and its benefit is contemplated in general for any mobile medical examination system, such as for example computer tomography (CT) system, diagnostic X-ray (DXR) system, radiation therapy (MR-Linac) system. In general, mobile medical examination systems are required to provide reliable and stable examination results. Circumstances during their transportation may affect critical elements that are essential for generating the examination results. Such critical elements may be the sources of the systems, e.g., magnets for the magnetic resonance examination systems, X-ray sources for any of CT and DXR systems.

It is understood that one or more of the aforementioned embodiments of the invention may be combined as long as the combined embodiments are not mutually exclusive.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

## Claims

1. A mounting structure (4) for a medical examination system (3),
the mounting structure (4) being configured for being placed onto a loading surface (6) and comprising:
elastically resilient elements (7) for supporting the medical examination system (3) on the loading surface (6),
transverse supports (8) for securing the medical examination system (3) from movements substantially parallel to the loading surface (6), and
wherein the transverse supports (8) comprise low-friction slide plates (9) configured for contacting the medical examination system (3).

2. The mounting structure (4) according to claim 1, wherein in operation, the low-friction slide plates (9) provide a stop surface for the medical examination system (3) that runs perpendicular to the loading surface (6).

3. The mounting structure (4) according to claim 1 or 2, wherein the surface of the low-friction slide plates (9) comprise polytetrafluoroethylene.

4. The mounting structure (4) according to any one of the previous claims, wherein the elastically resilient elements (7) comprise elastic pads (10), preferably made from an elastic material and/or springs (11).

5. The mounting structure (4) according to any one of the previous claims, wherein the transverse supports (8) are each provided with a slotted hole (12) through which a sliding pin (13) is fed which is fixed to the medical examination system (3) for allowing the medical examination system (3) to perform a predetermined limited vertical movement.

6. The mounting structure (4) according to claim 5, wherein the sliding pins (13) are each provided with a thread (14) for threading them into respective threaded holes (15) in the medical examination system (3).

7. The mounting structure (4) according to any one of the previous claims, wherein the medical examination system (3) comprises a foot structure (17) for placing the medical examination system (3) onto a flat surface for operation, wherein the elastically resilient elements (7) and the transverse supports (8) with the low-friction slide plates (9) are configured for supporting and securing the medical examination system (3) via its foot structure (17).

8. Use of a mounting structure (4) according to any one of claims 1 to 7 for supporting and securing a medical examination system (3).

9. Method of supporting and securing a medical examination system (3) on a loading surface (6), comprising:
elastically supporting the medical examination system (3) on the loading surface (6), and
securing the medical examination system (3) from movements substantially parallel to the loading surface (6), including contacting the magnetic resonance examination system (3) with low-friction slide plates (9).

10. The method according to claim 9, further comprising:
placing a mounting structure (4) onto the loading surface (6),
elastically supporting the medical examination system (3) on the loading surface (6) by elastically resilient elements (7) of the mounting structure (4),
securing the medical examination system (3) from movements substantially parallel to the loading surface (6) by transverse supports (8) of the mounting structure (4), and
contacting the medical examination system (3) with low-friction slide plates (9) which are arranged on the transverse supports (8).

11. The method according to claim 9 or 10, further comprising:
by the low-friction slide plates (9) on the transverse supports (8), providing a stop surface for the medical system (3) that runs perpendicular to the loading surface (6).

12. The method according to any one of the claims 9 to 11, further comprising:
allowing the medical examination system (3) to perform a predetermined limited vertical movement.

13. The method according to claim 12, further comprising:
allowing the medical examination system (3) to perform a predetermined limited vertical movement by slotted holes (12) in the transverse supports (8) through which sliding pins (13) are fed which are fixed to the medical examination system (3).

14. The method according to any one of claims 9 to 13, wherein the medical examination system (3) comprises a foot structure (17) for placing the medical examination system (3) onto a flat surface for operation, wherein the elastically resilient elements (7) and the transverse supports (8) with the low-friction slide plates (9) support and secure the medical examination system (3) via its foot structure (17).

15. Any one of the claims 1 to 14, wherein the medical examination system (3) is a magnetic resonance examination system (3) comprising a superconducting magnet (5).
